(19) Europäisches Patentamt
European Patent Office
Office européen des brevets

(11) **EP 4 377 992 B1**

(12) **EUROPEAN PATENT SPECIFICATION**

(45) Date of publication and mention
of the grant of the patent:
**18.06.2025 Bulletin 2025/25**

(21) Application number: **22750674.8**

(22) Date of filing: **08.07.2022**

(51) International Patent Classification (IPC):
*H01L 21/677* (2006.01)   *H01L 21/68* (2006.01)
*H01L 21/687* (2006.01)   *H01L 21/67* (2006.01)

(52) Cooperative Patent Classification (CPC):
**H01L 21/6719**

(86) International application number:
**PCT/EP2022/069134**

(87) International publication number:
**WO 2023/006387 (02.02.2023 Gazette 2023/05)**

(54) **PROCESS SHUTTER ARRANGEMENT**

PROZESSBLENDENANORDNUNG

AGENCEMENT D'OBTURATEUR DE TRAITEMENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.07.2021 CH 0701062021**

(43) Date of publication of application:
**05.06.2024 Bulletin 2024/23**

(73) Proprietor: **Evatec AG
9477 Trübbach (CH)**

(72) Inventors:
• **KERSCHBAUMER, Jörg
6800 Feldkirch (AT)**
• **FREI, Pascal
9470 Buchs (CH)**

(74) Representative: **Troesch Scheidegger Werner AG
Schwäntenmos 14
8126 Zumikon (CH)**

(56) References cited:
JP-A- 2013 057 108    JP-B2- 3 233 496
US-A1- 2011 147 618   US-A1- 2012 103 793
US-A1- 2014 271 081   US-A1- 2019 348 264

## Description

The invention refers to a process shutter arrangement according to claim 1, to a shutter disc according to claim 9, to a shutter arm according to claim 11, to a vacuum process system according to claim 12, and to a method to use a process shutter arrangement according to claim 14.

## Technical Background

Process shutter arrangements comprising a shutter disc, also known as dummy disc as it replaces a wafer which is usually processed on the chuck, and a shutter arm to rotate the disc from a niche of the processing chamber or a separate compartment towards a pedestal or chuck, which carries the wafer or other substrates during processing, are widely used in vacuum equipment for semiconductor and optical industries, for instance for conditioning or pasting processes to extend the replacement cycle of the process shields, or simply to cover the top of a chuck to protect it against dust or mechanical exposure during servicing. As such equipment is expensive and highly automized, service intervals should be minimized, and precision and reliability of any step be optimized. Due to shorter process times and respective high number of process cycles, a higher number of conditioning and/or pasting operations per time unit follows.

Definitions:

A dummy or shutter disc is a disc to replace a wafer in a processing position during a servicing, a conditioning, or a pasting step to protect the underlying equipment, especially the highly sensitive wafer bearing surface of the chuck. The disc should be able to receive a considerable amount of deposition material from the targets in case of target sputtering in the process chamber or allow a considerable amount of material to be removed when etching is performed during a so called conditioning or pasting step. When different sputter or conditioning/ pasting steps shall be performed, usually different discs will be used for sputtering or conditioning/pasting steps.

A shutter sickle is the part of a shutter arm which carries the shutter disc and is provided at least with the positioning tenons. The sickle can essentially have the form of a sickle, however, can be also disc or paddle like itself and having slots to let the pins of the chuck pass during rotational movement to and from a center position over the chuck. Therefore, the inner periphery of the sickle $D_{Si}$ can define an actual periphery of the sickle or the innermost position of at least one of the tenons, which preferably sit in a position having essentially the same distance from the center of the sickle.

In US20020088771A1 a shutter disk having notched areas is disclosed to be used with a shutter arm assembly for fully automated handling. However additional installations like a modified cover-ring have to be provided and connected with the shielding to avoid mutual movement, which makes the installation laborious and might influence the placing precision due to thermal expansion of the shields.

To center the position of the shutter disk it is further known to apply a sensor on a shaft coupled to a robotic driven arm to detect the respective rotational position. To improve the respective sensing system, the same applicant as above discloses in US7008517B1 a sputter disc which is centered by a central blind hole cooperating with an alignment post on a rotating blade. Therewith a relatively robust construction is necessary for the disc and the blade. At the same time the use of up to three different sensors is proposed to detect the disc in the housing.

Other prior art process shutter arrangements are known from US2014271081 A1 and US2012103793A1.

Therefore, there is a need for light and dimensionally minimized components which can be moved faster and enable a high placing precision of the shutter disc, without the use of sophisticated multi-sensor systems.

## Summary of the Invention

Surprisingly, it has been found that a respective process precision and high repeatability as well as minimized dimensions the components can be achieved by mere mechanical provisions of an inventive process shutter arrangement for a vacuum process system.

It is therefore an objective of the present invention to provide a process shutter arrangement comprising:

- a shutter disc having an essentially circumferential outer diameter $D_{Do}$, a thickness t, a first surface, and a second surface, the disc comprising at least three positioning mortises in the first surface near the outer diameter $D_{Do}$, each mortise being centered with respect to a radially axis $\xi_{1-3}$ in an xy-plane of the disc and having two long sides a positioned in parallel or right angled to axis $\xi_{1-3}$, so that each of the axes $\xi_{1-3}$ intersects at least one of the other axes in a center of the outer diameter $D_{Do}$. As an example, the mortises may be arranged in a 120° position to each other or within a 180° section of the disc, e.g. at 0°, 90° and 180°, at the same or in a different radially distance from the center of the disc;

- a shutter arm comprising a bearing sickle with an inner periphery $D_{Si}$, and at least three positioning tenons near or adjacent to the inner diameter $D_{Si}$, and corresponding with positioning mortises to position the disc when set on the positioning tenons or on an optional bearing surface of the sickle. Thereby the disc may sit directly on the bearing surface or on top of the tenons, depending on the height of the tenons and respective depth of the mortises and the provision of a bearing surface.

The bearing surface may extend radially from the inner periphery $D_{Si}$ of the sickle, e.g. in an outward direction and/or in a center direction. The tenons being positioned near or adjacent to the inner diameter $D_{Si}$.

The disc may further comprise a circumferential rim extending in a horizontally sidewise direction and/or in a vertically downward direction.

The mortises can be arranged within an inner diameter $D_{Ri}$ of the rim or within a projection of the inner positioning rim, and adjacent, e.g., immediately adjacent, to the rim or the projection. Mortises may have a basic rectangular geometry.

Depending on the type of process to be performed when the disc protects the chuck, the material or the coating respectively plating of the disc can be chosen. If only a coating or plating of the disc is provided, at least the second side of the disc should be coated or plated and, if not protected by a clamp or holder on the chuck during the pasting or conditioning step, the second side of the rim, and the periphery of the disc respectively rim. For conditioning or servicing stainless steel or for a lightweight construction titanium or a ceramic material will work, whereby ceramic can be any densely sintered ceramic, e.g., aluminum oxide, silicon nitride or silicon carbide. If, however a pasting process should be performed, a respective pasting material like titanium or aluminum can be used as well as more exotic pasting materials like ZrFe or Pt.

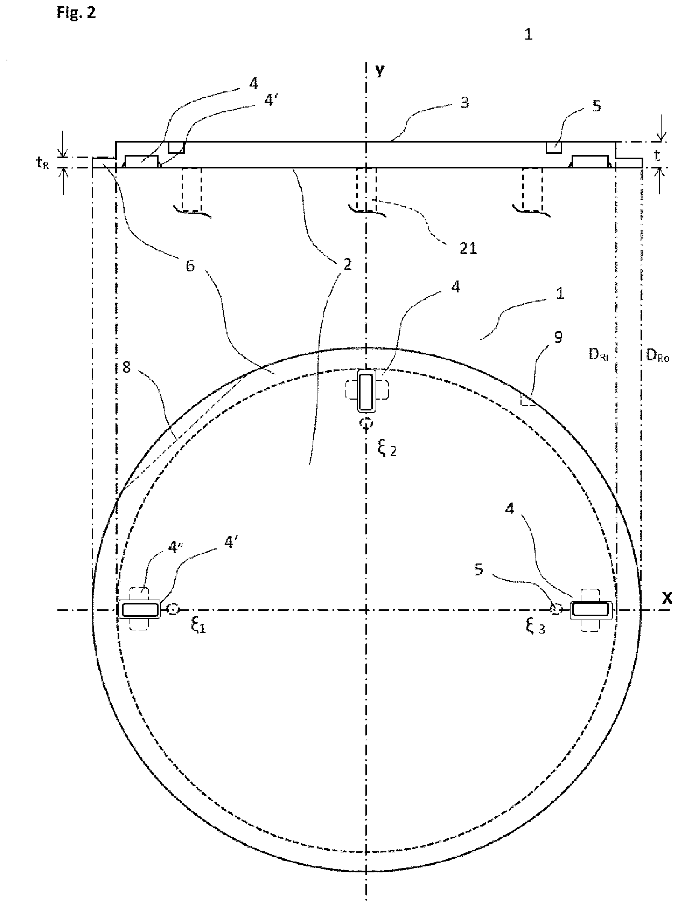

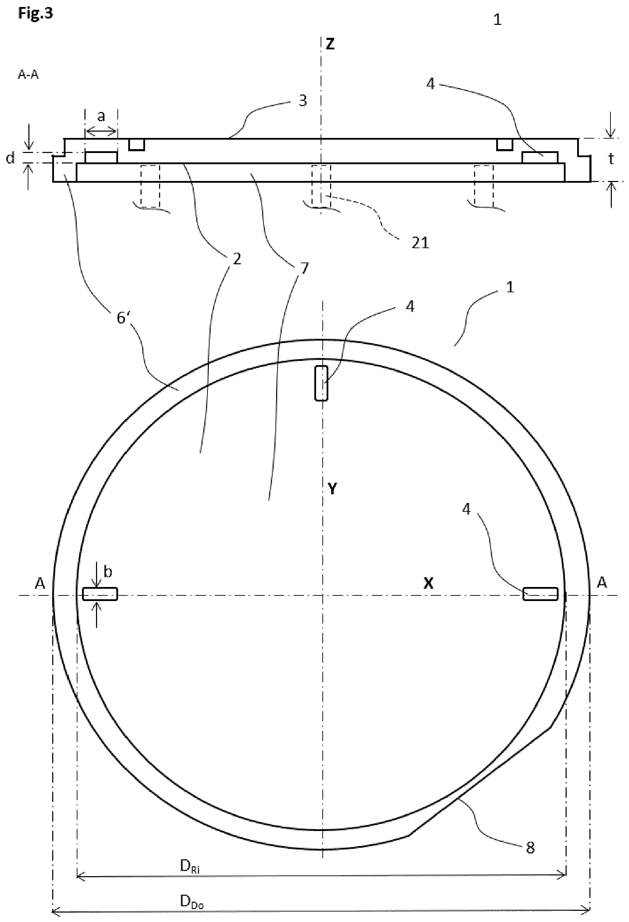

An inventive shutter arm may comprise a sidewall to enhance the stiffness of the sickle when space is limited. The sidewall may form at least in part an outer periphery $D_{So}$ of the sickle, whereat the outer diameter $D_{Do}$ of the disc fits into the inner periphery $D_{Wi}$ of the sidewall. The chuck dimension relates directly to the size of a wafer to be treated in a vacuum process which can be PVD, a CVD or an etch process as an example. With reference to the disc to chuck relation to be treated at the chuck, as an example for a disc having a flat first side as shown in Fig.2 below, a very small or even no oversize will suffice. The same may apply for a disc with a rim having a vertical extension over the first surface as shown in Fig.3. However, to avoid any contact to the wafer bearing surface when sitting on the top of the chuck, a few millimeters may be added for the rim in a radially outwards direction of the the wafer bearing surface, whereas a few tenth of a millimeter for the vertical extension suffice to avoid touching of an all flat wafer bearing surface of a chuck by the disc.

The sidewall of the sickle may encompass the bearing surface in an angular range of about180° or smaller and can be a continuous or a interrupted sidewall, e.g. a sequence of pins. The bearing surface of the sickle may extend over an angular range of 180° - 360° and will be usually of 230 ± 30° of the inner diameter $D_{Si}$.

Tenons may have a basic rectangular, a circular or an oval geometry and have to be symmetrically with reference to a middle plane extending along an axes $\eta_{1-3}$ and the height direction z of a tenon. When Tenons have a rectangular or square base, round corners or a circular end geometry will be usually provided.

The disc may further comprise a flat and/or a notch at or in its outer diameter $D_{Do}$, and the sickle may comprise a corresponding flat side and/or a nib, e.g., at the inner diameter $D_{Wi}$ of the side wall. Such features may be provided when the chuck to be protected has respective positioning nibs or flat sides for the wafer to be processed.

The shutter arm can be made of a material having an elastic modulus of at least 100 to 500 GPa to provide a high stiffness and avoid disturbing vibrations. Thereby densely sintered ceramic materials like aluminum oxide, silicon nitride, or silicon carbide are preferred due to their light weight.

In an alternative embodiment the position of tenons and mortises can be reversed, which means that tenons can be provided at the first surface of the disc and mortises can be provided at the bearing surface of the sickle.

It is a further objective of the present invention to provide a shutter disc having an essentially circumferential outer diameter $D_{Do}$, a thickness **t,** a first surface, and a second surface, the disc comprising at least three positioning mortises in the first surface near the outer diameter $D_{Do}$, each mortise being centered and symmetric with respect to a plane between a radially axis $\xi_{1-3}$ in an xy-plane of the disc and the respective vertical, and having two long sides **a** positioned in parallel or right angled to axis $\xi_{1-3}$. The mortises having further a short dimension b, and a depth dimension d, where b < a. It should be mentioned that neither positions of the mortises need to be regularly, nor need dimensions $a_{1-3}$. $b_{1-3}$, $d_{1-3}$, be the same for a, b or d. However, some regularly positions, e.g., 0°, 90°, 180°, and/or identical dimensions a, b, d for mortises as well as identical dimensions for the respective dimensions m, n, h for the tenons can ease manufacture and/or handling of the disc respectively sickle.

It is a further objective of the present invention to provide a shutter arm comprising a shaft with mounting means, a bearing sickle with an inner periphery $D_{Si}$, and at least three positioning tenons near or adjacent to the inner diameter $D_{Si}$, being in operative connection with positioning mortises to position the disc when set on the positioning tenons or on an optional bearing surface of the sickle. Thereby the disc may sit directly on the bearing surface or on top of the tenons, depending on the height of the tenons and respective depth of the mortises and the provision of a bearing surface.

The bearing surface may extend radially from the inner periphery $D_{Si}$ of the sickle, e.g., in an outward direction and/or in a center direction. The tenons being positioned near or adjacent to the inner diameter $D_{Si}$. The shutter arm further comprising a shaft with mounting means for the bearing sickle with a bearing surface radially extending from an inner periphery $D_{Si}$ of the sickle, and optionally a semi-circumferential side wall encompassing the bearing surface. Each tenant having an axis $\eta_{1-3}$ positioned radially in an xy-plane of the sickle, and a long dimension m, a short dimension n, and a height dimension h, when $n \le m$. When $n = m$ the tenon may have a circular or a square basis. Tenons are centered with reference to a plane comprising radially oriented axis $\eta_{1-3}$ and a respective vertical.

When the disc is mounted on the bearing surface of the sickle or on top of the tenons, tenons rest in respective mortises. Therefore, angular orientation and radial position of mortises and tenons has to be the same. As mentioned above mortises and tenons may be interchanged from the disc to the arm respectively vice-versa.

Due to positioning means which may be provided on the chuck to position wafers having a notch or a flat respective positioning means like a flat and a flat side, a notch and a nib, can be foreseen with the disc which replaces the wafer for the servicing, conditioning or pasting step, and the sickle to bear the respective disk. As an example, flats and/or notches may be provided at or in the outer diameter $D_{Do}$ of the disc, whereat the flat side and/or the nib may be provided at the inner periphery $D_{Wi}$ of the sidewall.

It is a further objective of the present invention to provide a vacuum process system comprising a vacuum process chamber which houses a chuck with pins being movably mounted in a z-direction to a pin drive and a process shutter arrangement as discussed above and will be further discussed at the hand of the figures below. Thereby the arm of the process shutter arrangement is mounted to a vacuum side of a rod having a vertical rotational axis R, the rod being mounted to the chamber by a feedthrough, and being in operative connection with a shutter drive at the atmosphere side of the rod, to rotate the arm in a horizontal plane from a niche of the processing chamber or a separate compartment in a central position over the chuck, to enable that the pins of the chuck take over the disc.

The pin drive of the chuck may be mounted to the process chamber, on atmosphere side or on the vacuum side. To lift the disc after the sickle has been rotated in a central position over the chuck, the drive may extend the pins in a uniform joint movement in an upper end position which can be between 5 and 30, e.g. 10 to 20 mm above the horizontal top of the chuck. Therefore, pins have to be provided within the inner diameter $D_{Si}$ of the sickle, when the latter is in the central position.

The process system may further comprise a control unit connected to the pin drive and the shutter drive to coordinate rotational movement of the arm and linear z-movement of the pins to rotate the arm with the disc and lift and lower the disc when the arm is in the central position.

The chuck of the process system can be a static chuck or a dynamic chuck which can be moved in a vertical direction from a loading position into a processing position and vice-versa.

For a static chuck at least a handling cut-out in the process shields with a drivingly movable screen-shutter can be provided, when only a niche for the rest or idle position of the sickle is foreseen. Additionally, a disc handling opening can be provided with a respective lock in the chamber wall when a separate compartment should be foreseen. Disc handling cut-out and disc handling opening being mutually aligned and tailored to allow handling of a plate shaped disc. This can be in analogy to the substrate handling arrangement as disclosed in WO 2017/215806 of the same applicant. Special reference is made to Fig.1 and respective description.

Similar provisions can be made for a dynamic chuck as shown in Fig.1 and respective description of WO 2017/207144 A1. Opening and closing of the handling cut-out in the process shields in this case can be performed by at least two telescopic cylindric shields encompassing the outer diameter of the chuck, whereat one of the shields is mounted to and moves with the chuck, whereby respective cut-outs are opened or closed by the respective other shield.

It is a further objective of the present invention to provide a method to use an inventive process shutter arrangement in a chamber of an inventive vacuum processing system as discussed above, whereat the method comprises the following steps:

- rotating the arrangement in a horizontal plane from the niche or the separate compartment in a central position over the chuck;
- extending the pins to lift the disc from the bearing surface in a horizontal plane above the shutter arm;
- rotating the empty arm back to the niche or the separate compartment;
- lowering and retracting the pins into the top surface of the chuck to cover the chuck with the disc;
- performing a conditioning, a pasting or a service operation in the process chamber.

The Method may further comprise the following steps:

- extending the pins to lift the disc from the chuck in a plane above the shutter arm;
- rotating the empty arm from the niche or the separate compartment in the central position over the chuck and below the disc;
- lowering the pins to the bearing surface of the sickle whereat precision positioning takes place by entering of the tenons into the mortises;
- retracting the pins in a horizontal plan below the shutter arm;

- rotating the loaded arm back to the niche or the separate compartment;

The invention shall now be further exemplified with the help of figures. Figures show the invention only in an exemplary way to outline the important features of the invention. The dimensions and geometrical relations of the different features as shown may differ from actual embodiments of the invention.

The figures show:

Fig.1:    a process system comprising an inventive process shutter arrangement;
Fig.2:    an inventive shutter disc;
Fig.3:    an alternative inventive shutter disc;
Fig.4:    an inventive shutter arm;
Fig.5:    detail of an inventive shutter arm;
Fig.6:    an alternative inventive shutter arm;
Fig.7:    a further embodiment of an inventive shutter arm.

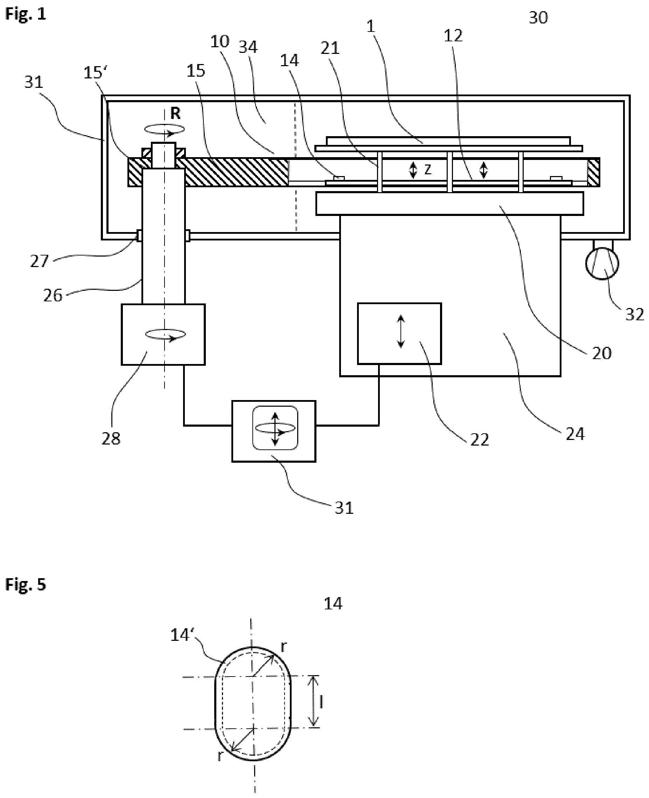

The components and relevant functional principles of a process system operating in a conditioning or pasting mode are shown at the hand of Fig.1. The exemplary process system 30 as shown has a vacuum pump 32 attached to the vacuum chamber 31 which houses a chuck 20 to process wafers or other flat substrates and an inventive process shutter arrangement consisting of a shutter disc 1 and a shutter arm 10. The shutter arm is mounted to the rod 26 of a shutter drive 28 to rotate the shutter disc from a niche 34 of the processing chamber 31 or a separate compartment 34 in a central position over the chuck. As usual the rod runs through a vacuum feedthrough 27. When positioned over the chuck 20, pins 21 lift the shutter disc 1 in z-direction according to the double arrows from the bearing surface 12 of the sickle 11. This is the very position which is shown in Fig.1 with pins 21 in fully extended position. It should be noted that the pins need not be necessarily lifted above the sidewall as schematically shown. A lift of one or some few millimeters may suffice, as long as the sidewall does not encompass more than 180° of the bearing surface, which allows a rotation of the sickle into and out of central position without touching the lifted disc with its sidewall. The pins 21 can be the pins as used to lift a wafer from a wafer blade. Thereafter the sickle 11 is rotated back into the niche 34 or separate chamber 34 and pins are retracted in the chuck surface to position the disc on the chuck to protect its surface during a following conditioning, pasting process or servicing operation. The present shutter disc and shutter arm can be designed extremely flat, so that only a short lift is necessary to enable the back-rotation of the arm with the disc unloaded from the sickle 11. The control unit 31 can be used to trigger and control respective rotational movement of the arm 10 and vertical movement of the pins 21, which can be initiated by an operator for service or by the system control (not shown) to which the control unit 31 may be integrated. The pin drive 22 which can be positioned on the atmosphere or the vacuum side of the process chamber 31, which also houses the pin transmission and further components (not shown) used for the operation of the chuck.

To load the disc 1 again on the sickle 11, the process is reversed, pins 21 are extended to lift the shutter disc 1 from the chuck 20 and the sickle 11 is rotated in a central position so that the bearing surface 12 is positioned between the chuck 20 and the lifted disc 1. For long term process stability with series of some hundred process / pasting / conditioning cycles or more it is very important that positioning of the sickle and picking up of the disc from the chuck is performed with utmost precision. Therefore, light weight but highly rigid materials having a high modulus of elasticity, e.g., at least 100 to 500 GPa, should be used for the arm and sickle to avoid any disturbing material deformation due to change of temperature or load. In the present case aluminum oxide was used as material for the shutter arm with the sickle, however other materials of similar properties, e.g., as shown above may be used too. The shutter drive motor 28 is coupled to the rod 26 and an encoder to ensure high position accuracy.

However most importantly the picking up of the disc by the sickle of the arm is supported by respective positioning features on the disc and sickle. So, when the disc is lowered by retraction of the pins towards the sickle and pins 21 are further retracted in a position at least below the bearing surface 12, precision positioning is completed by three positioning tenons 14 in the sickle surface 12 which enter into the respective mortises 4 in the lower disc surface 2, whereby the position of the disc 1 is perfectly defined on the bearing surface 12 of the sickle 11 before it is rotated back in rest position. Therewith for the next conditioning or pasting operation the shutter drive can rotate the arm with the disc in position above the chuck and handover the disc to the pins at the very right place without further measures.

It should be mentioned that especially the shown thickness dimensions of arm and sickle, and disk, as well as dimensions of the precision positioning features are oversized in the figures to better show the functionality.

It is further evident that vacuum process systems as shown in Fig.1 usually will have additional features like gas inlets for PVD or CVD processes, sputtering targets to deposit materials, etching devices or the like to process a wafer or other flat substrates, which only makes conditioning, pasting or service cycles necessary. However, as the present invention focuses on the improvement of a process sputter arrangement, only respective relevant installations are discussed and shown in the figures.

A shutter disc 1 with three positioning mortises 4 in a first surface 2 and a rim 6 optionally provided with a flat 8 and/or a notch 9 is shown in Fig.2. The shutter disc having a thickness t, the mortises having a length a, a width b, and a depth d (see also Fig.3) and being positioned with their longitudinal axes $\xi_{1-3}$ radially in a peripheral position at 0°, 90° and 180° of the disc perimeter. The disc also comprises three nicks 5 in a second surface 3 of the disc 1, positioned on an inner extension of the projection of axes $\xi_{1-3}$, adjacent to mortises 4. These nicks can be used for a first placing step, e.g. during a first manual placing of the disc. Similarly nicks and/or bevels can be used with any other embodiment of a shutter disc. Mortises can have a circumferential bevel 4' and tenons can have a circumferential chamfer 14', each alone or in cooperation with each other to ease matching of the two positioning elements. Mortises 4 can be positioned on axis $\xi_{1-3}$ in parallel and symmetric to it as indicated in solid lines, or alternatively right angled to axis $\xi_{1-3}$ as indicated in dashed lines and reference number 4", which will usually be also symmetric as referred to before.

In Fig.3 a similar shutter disc 1 with three positioning mortises 4 in the first surface 2 and a rim 6 here provided with a flat 8 is shown. In the case of the disk in Fig.3 the rim 6 also has a vertical extension which slightly towers over the first surface 2 and thereby may encompass the wafer bearing surface of the chuck 20 and sit on a peripheral chuck surface.

Despite of the fact, that the disks as shown in Fig.2 and Fig.3 can be designed very flat with a thickness t from 2 to 20 mm, or 3 to 10 mm, the provision of a rim 6 of lower thickness $t_R$, which should refer to the thickness of a wafer to be processed, can make it easy to clamp the disc on the chuck with usual wafer clamps, e.g. during sputtering processes. As far as provided, the rim 6 can be small but at the same time wide enough to provide place for the positioning flat 8 or notch 9. As an example, disc dimensions for a 300 mm chuck, which are usual chuck dimensions to process 300 mm wafers, can be:

$$300.2 \leq D_{DO} \leq 305 \text{ mm}, \quad 293 \leq D_{Ri} \leq 298 \text{ mm}.$$

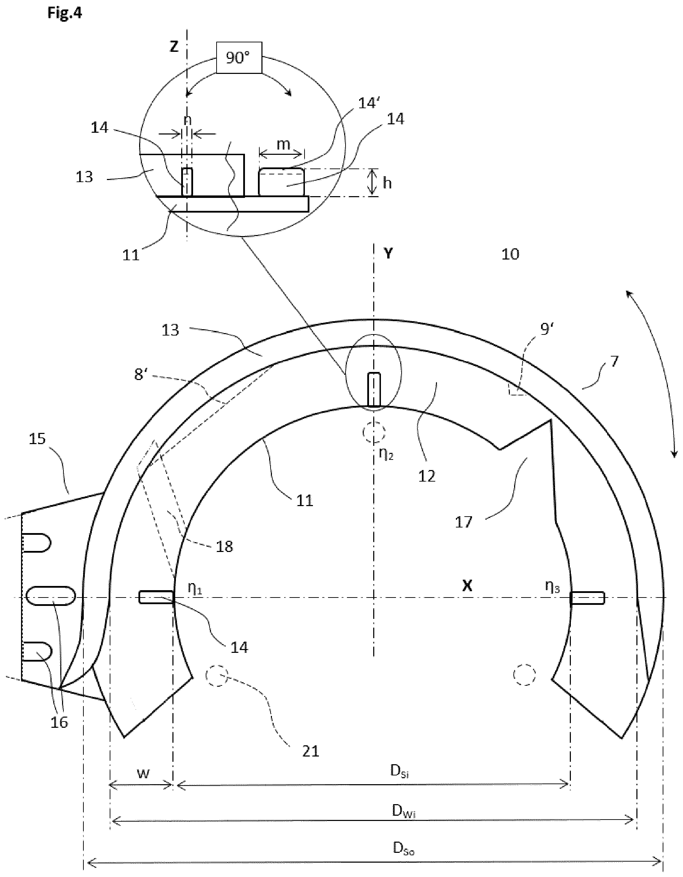

A shutter disk arm 10 which can be mounted to the rod 26 of a rotation unit by a shaft 15 with flange and positioning slots 16 to level the sickle is shown in Fig.4. Alternatively, or in addition a central mounting on the shaft, as shown in Fig.1, can be foreseen.

The arm 10 further comprises a sickle 11 with a bearing surface 12 and sidewall 13. Three positioning tenants 14, each offset by 90° from the next tenant, are placed on the bearing surface 11 next to the inner diameter of the sickle, with their axes $\eta_{1-3}$ arranged radially towards the inner periphery of the sickle $D_{Si}$. Therewith, when the disc 1 is positioned on the sickle 11 axes $\xi_{1-3}$ of mortises 4 and axes $\eta_{1-3}$ of the tenants 14 coincide and the inner periphery $D_{Wi}$ of the sidewall 13 encompasses the outer diameter $D_{Do}$ of the disc 1 on the bearing surface 12. To ensure highest positioning precision the small dimension **b** of the mortise 4 and the respective dimension **n** of the tenant 14 should be very similarly sized so that, as an example in the case of an arrangement for a 300 mm wafer, the difference should be about b - n = 0.1 ± 0.05 mm. In contrast to that the long dimension **a** of the mortise 4 should be provided considerably longer than the respective dimension **m** of the tenant 14 to enable thermal compensation. As an example, again for a 300 mm wafer arrangement, when using a metal disc and a ceramic sickle, the difference should be at least 1 to 3 mm, depending on the maximal thermal load during processing. When nibs or flat sides are used to position the wafer on the chuck, a flat side 8' and/or a nib 9' can be foreseen as shown in dashed lines. Reference number 17 refers to an optional out-cut to allow an optical sensor (not shown), to acknowledge correct positioning of the disc. The optical sensor can be mounted in a niche or a separate rest chamber for the arm and disc or can be integrated on the arm 10. One or more openings 18 as shown in dotted lines may be provided in the bearing surface 11 and a lower part of the side wall 13 to allow protrusions from the chuck or pins positioned further outward on the chuck to pass. Width w of the bearing surface should be from at least about 1.5 the length m of a tenon till about 30 mm to allow pins 21 to pass inside when lifting the disc 1.

The magnifying glass in the upper part of the drawing shows on the left side a view from the center of the sickle 11 towards a tenant 14 on the bearing surface 12 and a sideview in a 90° perspective to the left side.

Tenants may have a maximal length dimension **m,** a maximal width dimension **n,** and a height **h** whereby:

$$2 \leq m < 20 \text{ mm}$$

$$2 \leq n < 20 \text{ mm}$$

$$1 \leq h < 10 \text{ mm}.$$

Therewith mortises having a maximal length dimension **a** and a maximal width dimension **b,** can be used with the following dimensions:

$$2 < a \leq 20 \text{ mm}$$

$$2 < b \leq 20 \text{ mm}$$

$$1 < d \leq 10 \text{ mm.}$$

Fig.5 shows further details of a positioning tenant 14 in top view. The tenant 14 comprising two circular edge sections of radius r, a straight middle part here of length l, and an upper finish with a circumferential chamfer 14'. As an example, r can be 2 mm and height h of the tenant can be also 2 mm. Thereby minimized dimensions and good positioning properties can be achieved. A variation of the length l of the straight middle part can be from about 0 to 4r or more, which may depend of the width $w = (D_{Wi} - D_{Si}) / 2$ of the bearing surface 12. Alternatively, round tenants, tenants with an oval base or other convenient base forms as known to the man skilled in the art can be used.

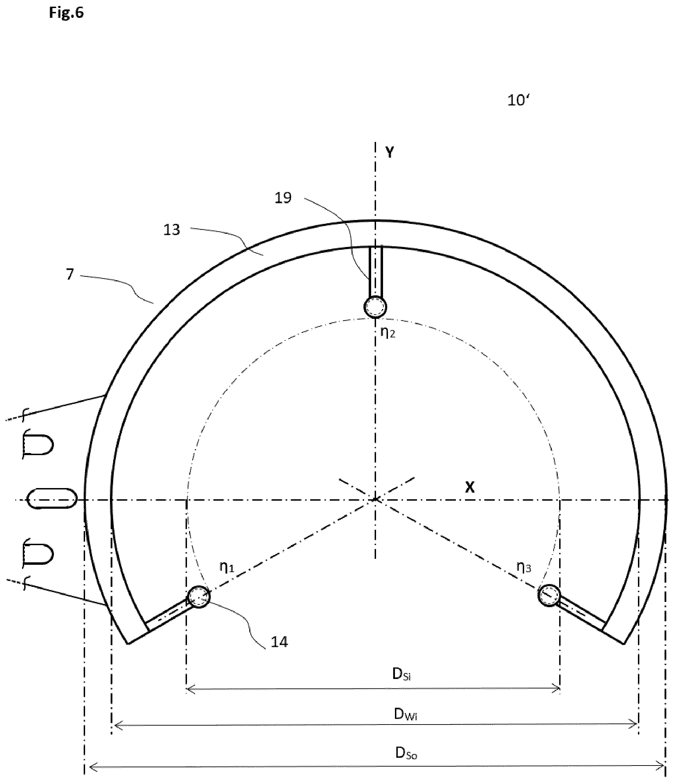

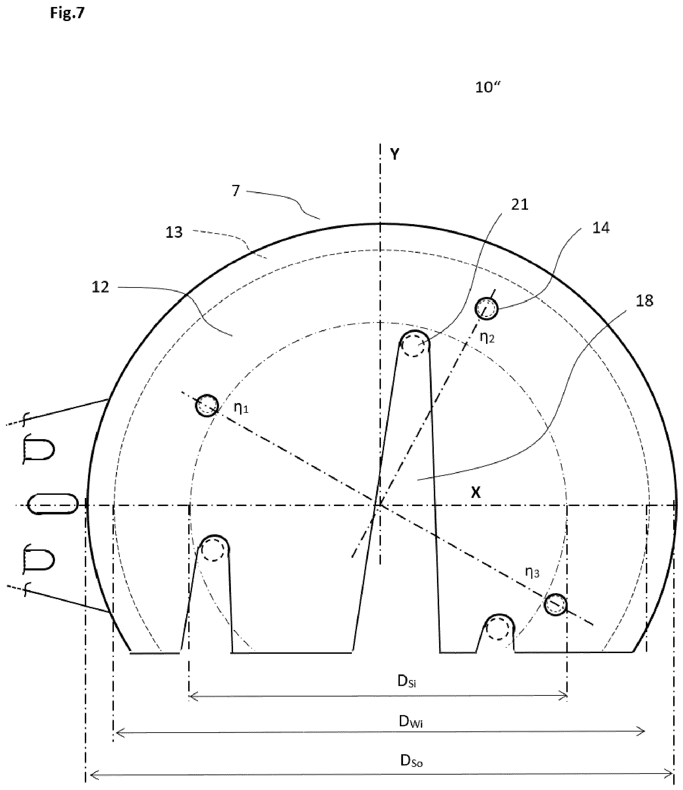

A further embodiment of an inventive shutter arm is shown in Fig.6. Contrary to the forgoing arm embodiment in this case circular tenons 14, mounted on an inner end of cantilevers 19, are used to position and hold the respective disc, which means the disc sits on the tenons only. The cantilevers project radially from the side wall 13 towards the center of the sickle 7. To hold the disc save in balance, the tenons are placed in a 120° position from each other at a mere virtual inner periphery of the sickle $D_{Si}$, so that there is no further need of the bearing surface 12 as shown in Fig.4 or Fig.7. Axes $\eta_{1-3}$ cut each other in the center point of the sickle. Such a shutter arm can be combined with any of the previous disc embodiments when the mortises are arranged in a respective 120° position.

A further inventive shutter arm in the form of a cut off disc is shown in Fig.7. With this embodiment shutter arm 10" again has three positioning tenons with axes $\eta_{1-3}$ in a 0°, 90°, and 180° configuration. Bearing surface 12 in this case may comprise the whole or a part of the upper surface of the sickle 7 till its outer periphery $D_{So}$, here comprising also the cut-off-line, when the thickness of the sickle, respectively bearing surface can be chosen big enough to provide stability and stiffness, which is easier for a paddle or disc-like sickle as shown with Fig.7. Otherwise, a rim 13 can be provided also with such sickle types to ensure as mentioned mechanical properties. To allow pins 21 of the chuck 20 to stay in their extended end position after they have taken over the disc 1 from the shutter disc arrangement, and the arm with the sickle has to rotate back in its rest position, three openings 18 are provided which allow the arm to rotate without touching the pins 21. Once again, the inner periphery of the sickle $D_{Si}$ is only virtual here and, as an example, can be defined by an inner periphery touching the innermost position of two tenons 14 whereat a third tenon may be positioned away from the respective periphery, here in a further outward direction. In principle however, each tenon can sit on the same or a different periphery with any embodiment of the invention, whereas positions near within, at the inner periphery or especially between the inner periphery and the rim are preferred due to ease and precision of positioning. Other positions of tenons and mortises may be chosen with any embodiment, with reference to different angular arrangements and/or different distances from the center for different tenons/mortises, up to the specific geometric needs within vacuum process chambers. And so can tenons and respective mortises of different geometry be combined with any of the shutter arm or disc embodiments as described in the examples.

**Reference Numbers**

| I | SHUTTER DISC |
|---|---|
| 1 | disc |
| 2 | first surface |
| 3 | second surface |
| 4 | positioning mortise in parallel to axis $\xi_{1-3}$ |
| 4' | bevel |
| 4" | alternative mortise, right angled to axis $\xi_{1-3}$ |
| 5 | control nick (second surface) |
| 6, 6' | rim |
| 7 | recess |
| 8 | flat |
| 9 | notch |
| a, b, d | long, short side, depth of a mortise |
| $D_{Do}$ | outer diameter of the disc |
| $D_{Ri}$ | inner diameter of the rim |
| t | thickness disc |
| $t_R$ | thickness rim |
| $\xi_{1-3}$ | longitudinal axis of a notch |

| II | PROCESS SHUTTER ARM |
|---|---|
| 8' | flat side |
| 9' | nib |
| 10,10',10" | arm |
| 11 | bearing sickle |
| 12 | bearing surface |
| 13 | side wall |
| 14 | positioning tenon |
| 14' | chamfer |
| 15 | shaft |
| 15' | flange |
| 16 | positioning slot |
| 17 | out-cut for sensor |
| 18 | opening |
| 19 | cantilever |
| $D_{Si}$ | inner periphery of the sickle |
| $D_{Wi}$ | inner periphery of the side wall |
| $D_{So}$ | outer periphery of the sickle |
| m, n, h | long, short side, height of a tenon |
| w | width of the bearing surface |
| $\eta_{1-3}$ | longitudinal axis of a tenant |
| III | CHUCK |
| 20 | chuck |
| 21 | pin |
| 22 | pin drive |
| 23 | chuck surface |
| 24 | chuck base |
| IV | ROTATION UNIT |
| 26 | shutter rod |
| 27 | rod feedthrough |
| 28 | shutter drive (motor, encoder, gear) |
| R | vertical axis of the rod |
| V | PROCESS SYSTEM |
| 30 | process system |
| 31 | vacuum process chamber |
| 32 | control unit |
| 33 | vacuum pump |
| 34 | niche or separate chamber |

**Claims**

1. A process shutter arrangement for a vacuum process system comprising:

   - a shutter disc (1) having an essentially circumferential outer diameter $D_{Do}$, a thickness **t,** a first surface (2), and a second surface (3), the disc comprising at least three positioning mortises (4) in the first surface (2) near the outer diameter $D_{Do}$, each mortise being centered with respect to a radially axis $\xi_{1-3}$ in an xy-plane of the disc and having two long sides a positioned in parallel or right angled to the respective axis $\xi_{1-3}$;
   - a shutter arm (10) comprising a bearing sickle (11) with an inner periphery $D_{Si}$, and at least three positioning tenons near or adjacent to the inner diameter $D_{Si}$, and corresponding with positioning mortises (4) to position the disc when set on the positioning tenons or on an optional bearing surface of the sickle.

2. The arrangement according to claim 1, wherein the bearing surface (12) extends radially from the inner periphery $D_{Si}$ of the sickle, the tenons being positioned near or adjacent to the inner diameter $D_{Si}$.

3. The arrangement according to claim 1 or 2, wherein the disc further comprises a circumferential rim (6, 6') extending in a horizontally sidewise direction and/or in a vertically downward direction, wherein the mortises are arranged optionally within an inner diameter $D_{Ri}$ of the rim or within a projection of the inner positioning rim, and adjacent to the rim or the projection.

4. The arrangement according to one of the forgoing claims, wherein the mortises have a basic rectangular geometry, and/or the disc is coated with or made of a metal or a ceramic material.

5. The arrangement according to one of the forgoing claims, wherein the shutter arm comprises a sidewall forming at least in part an outer periphery $D_{So}$ of the sickle, whereat the outer diameter $D_{Do}$ of the disc fits into the inner periphery $D_{Wi}$ of the sidewall, wherein optionally the sidewall encompasses about semi-circularly the bearing surface, or the tenons are mounted on cantilevers projecting from the side wall.

6. The arrangement according to one of the forgoing claims, wherein the bearing surface of the sickle extends over an angular range of 180 - 360° of the inner diameter $D_{Si}$ of the sickle.

7. The arrangement according to one of the forgoing claims, wherein the tenons have a basic rectangular, a circular, or an oval geometry, wherein preferably the tenons have a rectangular or square base with round corners or a circular end geometry.

8. The arrangement according to one of the forgoing claims, wherein the arm is made of a material having a modulus of elasticity which is at least 100 GPa, especially a respective ceramic material, and/or the tenons are provided at the first surface of the disc and the mortises are provided at the bearing surface of the sickle or on cantilevers projecting from the side wall.

9. A shutter disc having an essentially circumferential outer diameter $D_{Do}$, a thickness **t**, a first surface (2), and a second surface (3), the disc comprising at least three positioning mortises (4) in the first surface (2) near the outer diameter $D_{Do}$, each mortise being centered and symmetric with respect to a plane between a radially axis $\xi_{1-3}$ in an xy-plane of the disc and the respective vertical, and having two long sides **a** positioned in parallel or right angled to axis $\xi_{1-3}$, and a short dimension **b,** and a depth dimension **d**, where **b < a.**

10. A shutter disc according to claim 9, wherein the second surface comprises at least one control nick.

11. A shutter arm (10) comprising a shaft (15) with mounting means, a bearing sickle (11) with an inner periphery $D_{Si}$, and at least three positioning tenons near or adjacent to an inner diameter $D_{Si}$ of the sickle each tenant being positioned on a radially axis $\eta_{1-3}$ in an xy-plane of the sickle and symmetrically with reference to a middle plane extending along the respective axes $\eta_{1-3}$ and the height direction z, each tenon having a long dimension m, a short dimension n, and a height dimension h, where $n \leq m$.

12. A vacuum process system comprising a vacuum process chamber (31) housing a chuck with pins (21) being movably mounted in a z-direction to a pin drive (22) and a process shutter arrangement according to one of claims 1 to 8, whereat the arm 10 of the arrangement is mounted to a vacuum side of a rod having a vertical rotational axis R, being mounted to the chamber by a feedthrough, and being in operative connection with a shutter drive at the atmosphere side of the rod, to rotate the arm from a niche of the processing chamber or a separate compartment in a central position over the chuck, whereat preferably the pin drive is mounted to the process chamber on atmosphere or on the vacuum side.

13. The process system according to claim 12 further comprising a control unit connected to the pin drive and the shutter drive to coordinate rotational movement of the arm and linear z-movement of the pins to rotate the arm with the disc and lift and lower the disc when the arm is in the central position.

14. Method to use a process shutter arrangement according to one of claims 1 to 8 in a chamber of a vacuum process system according to claim 12 or 13 comprising the following steps:

  - rotating the arrangement in a horizontal plane from the niche or the separate compartment in a central position over the chuck;
  - extending the pins to lift the disc from the bearing surface in a horizontal plane above the arm;
  - rotating the empty arm back to the niche or the separate compartment;
  - lowering and retracting the pins into the top surface of the chuck to cover the chuck with the disc;
  - performing a conditioning, a pasting or a service operation in the process chamber.

15. Method according to claim 14 further comprising the following steps:

- extending the pins to lift the disc from the chuck in a plane above the arm;
- rotating the empty arm from the niche or the separate compartment in the central position over the chuck and below the disc;
- lowering the pins to the bearing surface of the sickle whereat precision positioning takes place by entering of the tenons into the mortises;
- retracting the pins in a horizontal plane below the arm;
- rotating the loaded arm back to the niche or the separate compartment.

**Patentansprüche**

1. Eine Prozessverschlussanordnung für ein Vakuumprozesssystem, umfassend:

   - eine Verschlussscheibe (1) mit einem im Wesentlichen kreisförmigen Außendurchmesser $D_{DO}$, einer Dicke t, einer ersten Oberfläche (2) und einer zweiten Oberfläche (3), wobei die Scheibe mindestens drei Positionierungsnuten (4) in der ersten Oberfläche (2) in der Nähe des Außendurchmessers $D_{DO}$ aufweist, wobei jede Nut in Bezug auf eine radiale Achse $\xi_{1-3}$ in einer xy-Ebene der Scheibe zentriert ist und zwei lange Seiten a aufweist, die parallel oder rechtwinklig zu der jeweiligen Achse $\xi_{1-3}$ positioniert sind;
   - einen Verschlussarm (10), der eine Lagersichel (11) mit einem Innenumfang $D_{Si}$ und mindestens drei Positionierungszapfen angrenzend oder in der Nähe des Innendurchmessers $D_{Si}$ und mit Positionierungsnuten (4) korrespondierend, um die Scheibe zu positionieren, wenn sie auf die Positionierungszapfen oder auf eine optionale Lagerfläche der Sichel gesetzt wird.

2. Die Anordnung nach Anspruch 1, wobei sich die Lagerfläche (12) radial vom Innenumfang $D_{Si}$ der Sichel erstreckt, wobei die Zapfen in der Nähe des Innendurchmessers $D_{Si}$ oder angrenzend daran angeordnet sind.

3. Die Anordnung nach Anspruch 1 oder 2, wobei die Scheibe außerdem einen umlaufenden Rand (6, 6') aufweist, der sich horizontal zur Seite und/oder vertikal nach unten erstreckt, wobei die Zapfenlöcher optional innerhalb eines Innendurchmessers $D_{Ri}$ des Randes oder innerhalb eines Vorsprungs des inneren Positionierrandes und benachbart zum Rand oder dem Vorsprung angeordnet sind.

4. Die Anordnung nach einem der vorhergehenden Ansprüche, wobei die Zapfenlöcher eine rechteckige Grundgeometrie aufweisen, und/oder die Scheibe mit einem metallischen oder keramischen Werkstoff beschichtet ist oder aus einem solchen besteht.

5. Die Anordnung nach einem der vorhergehenden Ansprüche, wobei der Verschlussarm eine Seitenwand umfasst, die zumindest teilweise einen Außenumfang $D_{So}$ der Sichel bildet, wobei die äussere Peripherie $D_{Do}$ der Scheibe in die innere Peripherie $D_{Wi}$ der Seitenwand passt, wobei die Seitenwand optional die Auflagefläche etwa halbkreisförmig umschließt, oder die Zapfen auf Auslegern montiert sind, die von der Seitenwand abstehen.

6. Die Anordnung nach einem der vorhergehenden Ansprüche, wobei sich die Auflagefläche der Sichel über einen Winkelbereich von 180 - 360° des Innendurchmessers $D_{si}$ der Sichel erstreckt.

7. Die Anordnung nach einem der vorhergehenden Ansprüche, wobei die Zapfen eine rechteckige, kreisförmige oder ovale Grundgeometrie aufweisen, wobei die Zapfen bevorzugt eine rechteckige oder quadratische Basis mit runden Ecken oder einer kreisförmigen Endgeometrie aufweisen.

8. Die Anordnung nach einem der vorhergehenden Ansprüche, wobei der Arm aus einem Material mit einem Elastizitätsmodul von mindestens 100 GPa, insbesondere einem entsprechenden keramischen Material besteht und/oder die Zapfen an der ersten Oberfläche der Scheibe vorgesehen sind und die Nuten an der Auflagefläche der Sichel oder an von der Seitenwand abstehenden Auslegern vorgesehen sind.

9. Eine Verschlussscheibe umfassend einen im Wesentlichen kreisförmigen Außendurchmesser $D_{Do}$, einer Dicke t, einer ersten Oberfläche (2) und einer zweiten Oberfläche (3), wobei die Scheibe mindestens drei Positionierungsnuten (4) in der ersten Oberfläche (2) in der Nähe des Außendurchmessers $D_{Do}$ aufweist, wobei jede Nut zentriert und symmetrisch in Bezug auf eine Ebene zwischen einer radialen Achse $\xi_{1-3}$ in einer xy-Ebene der Scheibe und der jeweiligen Vertikalen ist, und zwei lange Seiten a aufweist, die parallel oder rechtwinklig zur Achse $\xi_{1-3}$ positioniert sind, sowie eine kurze Abmessung b und eine Tiefenabmessung d, wobei b < a.

10. Eine Verschlussscheibe nach Anspruch 9, wobei die zweite Oberfläche mindestens eine Steuerkerbe umfasst.

11. Ein Verschlussarm (10) mit einer Welle (15) mit Montagemitteln, einer Lagersichel (11) mit einem Innenumfang $D_{si}$ und mindestens drei Positionierungszapfen in der Nähe oder angrenzend an einen Innendurchmesser $D_{si}$ der Sichel, wobei jeder Zapfen auf einer radialen Achse $\eta_{1\text{-}3}$ in einer xy-Ebene der Sichel und symmetrisch in Bezug auf eine Zentralebene positioniert ist, die sich entlang der jeweiligen Achsen $\eta_{1\text{-}3}$ und der Höhenrichtung z erstreckt, und jeder Zapfen eine lange Abmessung m, eine kurze Abmessung n und eine Höhenabmessung h aufweist, wobei $n \leq m$.

12. Ein Vakuumprozesssystem, das eine Vakuumprozesskammer (31) umfasst, die einen Chuck mit Stiften (21) umfasst, die in einer Z-Richtung beweglich an einem Stiftantrieb (22) angebracht sind und eine Prozessverschlussanordnung nach einem der Ansprüche 1 bis 8, wobei der Arm 10 der Anordnung an einer Vakuumseite einer Stange mit einer vertikalen Drehachse R montiert ist und durch eine Durchführung an der Kammer montiert ist und in operativer Verbindung mit einem Verschlussantrieb an der Atmosphärenseite der Stange steht, um den Arm aus einer Nische der Verarbeitungskammer oder einem separaten Abteil in eine zentrale Position über dem Chuck zu drehen, wobei der Stiftantrieb vorzugsweise an der Prozesskammer auf der Atmosphären- oder der Vakuumseite montiert ist.

13. Das Prozesssystem gemäß Anspruch 12 umfassend außerdem eine Steuereinheit, die mit dem Stiftantrieb und dem Verschlussantrieb verbunden ist, um eine Drehbewegung des Arms und die lineare Z-Bewegung der Stifte zu koordinieren, um den Arm mit der Scheibe zu drehen und die Scheibe anzuheben und abzusenken, wenn sich der Arm in der Zentralposition befindet.

14. Verfahren zum Einsatz einer Prozessverschlussanordnung nach einem der Ansprüche 1 bis 8 in einer Kammer eines Vakuumprozesssystems gemäss Anspruch 12 oder 13 umfassend die folgenden Schritte:

   - Drehen der Anordnung in einer horizontalen Ebene aus der Nische oder dem separaten Abteil in eine zentrale Position über dem Chuck;
   - Ausfahren der Stifte, um die Scheibe von der Auflagefläche in eine horizontale Ebene über dem Arm anzuheben;
   - Zurückdrehen des leeren Arms in die Nische oder das separate Abteil;
   - Absenken und Zurückziehen der Stifte in die obere Fläche des Chucks, um den Chuck mit der Scheibe abzudecken;
   - Durchführen einer Konditionierung, einer Klebung oder eines Servicevorgangs in der Prozesskammer.

15. Verfahren nach Anspruch 14 weiter umfassend die folgenden Schritte umfasst:

   - Ausfahren der Stifte, um die Scheibe aus dem Chuck in eine Ebene über dem Arm zu heben;
   - Drehen des leeren Arms aus der Nische oder dem separaten Abteil in die Zentralposition über dem Chuck und unter der Scheibe;
   - Absenken der Stifte auf die Auflagefläche der Sichel, wobei durch Eintreten der Zapfen in die Zapfenlöcher eine präzise Positionierung erfolgt;
   - Zurückziehen der Stifte in eine horizontale Ebene unterhalb des Arms;
   - Zurückdrehen des beladenen Arms in die Nische oder das separate Abteil.

## Revendications

1. Agencement d'obturateur de processus pour système de traitement sous vide, comprenant :

   - un disque obturateur (1) présentant un diamètre extérieur $D_{Do}$ essentiellement circonférentiel, une épaisseur t, une première surface (2) et une seconde surface (3), le disque comprenant au moins trois mortaises de positionnement (4) dans la première surface (2), près du diamètre extérieur $D_{Do}$, chaque mortaise étant centrée par rapport à un axe $\xi_{1\text{-}3}$ radialement dans un plan x-y du disque et présentant deux côtés longs a positionnés parallèlement à l'axe respectif $\xi_{1\text{-}3}$ ou perpendiculairement à celui-ci ;
   - un bras d'obturateur (10) comprenant un élément porteur en forme de croissant (11) présentant une périphérie intérieure $D_{S1}$, et au moins trois tenons de positionnement proches de ou adjacents au diamètre intérieur $D_{S1}$, et correspondant avec mortaises de positionnement (4) afin de positionner le disque lorsqu'il est placé sur les tenons de positionnement ou sur une surface porteuse facultative de l'élément en forme de croissant.

**2.** Agencement selon la revendication 1, dans lequel la surface porteuse (12) s'étend radialement depuis la périphérie intérieure $D_{S1}$ de l'élément en forme de croissant, les tenons étant positionnés près de ou adjacents au diamètre intérieur $D_{S1}$.

**3.** Agencement selon la revendication 1 ou 2, dans lequel le disque comprend en outre une rainure circonférentielle (6, 6') qui s'étend dans une direction latéralement horizontale et/ou dans une direction verticale vers le bas, dans lequel les mortaises sont disposées en option au sein d'un diamètre intérieur $D_{Ri}$ de la rainure ou au sein d'une projection intérieure de la rainure de positionnement et adjacentes à la rainure ou à la projection.

**4.** Agencement selon l'une des revendications précédentes, dans lequel les mortaises ont une géométrie de base rectangulaire et/ou le disque est revêtu avec ou réalisé dans un métal ou un matériau céramique.

**5.** Agencement selon l'une des revendications précédentes, dans lequel le bras d'obturateur comprend une paroi latérale formant au moins en partie une périphérie extérieure $D_{So}$ de l'élément en forme de croissant, le diamètre extérieur $D_{Do}$ du disque s'insérant dans la périphérie intérieure $D_{Wi}$ de la paroi latérale, et en option, la paroi latérale englobant environ de façon semi-circulaire la surface porteuse, ou les tenons étant montés sur des consoles qui font saille depuis la paroi latérale.

**6.** Agencement selon l'une des revendications précédentes, dans lequel la surface porteuse de l'élément en forme de croissant s'étend sur une plage angulaire de 180 à 360 ° du diamètre intérieur $D_{Si}$ de l'élément en forme de croissant.

**7.** Agencement selon l'une des revendications précédentes, dans lequel les tenons présentent une géométrie de base rectangulaire, circulaire ou ovale, dans lequel de préférence les tenons ont de préférence une base rectangulaire ou carrée avec des coins arrondis, ou une géométrie d'extrémité circulaire.

**8.** Agencement selon l'une des revendications précédentes, dans lequel le bras est fait d'un matériau présentant un module d'élasticité qui est au moins égal à 100 GPa, en particulier un matériau céramique respectif, et/ou les tenons sont prévus au niveau de la première surface du disque et les mortaises sont prévues au niveau de la surface porteuse de l'élément en forme de croissant ou sur les consoles faisant saillie depuis la paroi latérale.

**9.** Disque obturateur présentant un diamètre extérieur $D_{Do}$ essentiellement circonférentiel, une épaisseur t, une première surface (2), et une seconde surface (3), le disque comprenant au moins trois mortaises de positionnement (4) dans la première surface (2) près du diamètre extérieur $D_{Do}$, chaque mortaise étant centrée et symétrique par rapport à un plan entre un axe $\xi_{1\text{-}3}$ radialement dans un plan x-y du disque et la verticale respective, et présentant deux côtés longs a positionnés en parallèle ou à angle droit par rapport à l'axe $\xi_{1\text{-}3}$, et une dimension courte b, et une dimension de profondeur d, où b < a.

**10.** Disque obturateur selon la revendication 9, dans lequel la seconde surface comprend au moins une encoche de contrôle.

**11.** Bras d'obturateur (10) comprenant un arbre (15) présentant des moyens de montage, un élément porteur en forme de croissant (11) ayant une périphérie intérieure $D_{S1}$, et au moins trois tenons de positionnement près de ou adjacents à un diamètre intérieur $D_{S1}$ de l'élément en forme de croissant, chaque tenon étant positionné sur un axe $\eta_{1\text{-}3}$ radialement dans un plan x-y de l'élément en forme de croissant et symétriquement par rapport à un plan médian qui s'étend le long des axes $\eta_{1\text{-}3}$ respectifs et la direction de hauteur z, chaque tenon ayant une dimension longue m, une dimension courte n, et une dimension de hauteur h, où n $\leq$ m.

**12.** Système de traitement sous vide comprenant une chambre de traitement sous vide (31) logeant un plateau de maintien avec des broches (21) qui sont montées de façon mobile dans une direction z sur un entraînement de broche (22), et un agencement d'obturateur de processus selon l'une des revendications 1 à 8, le bras 10 de l'agencement étant monté sur un côté vide d'une tige présentant un axe de rotation vertical R, montée dans la chambre par une traversée, et se trouvant en connexion fonctionnelle avec un entraîneur d'obturateur côté atmosphère de la tige, afin de faire pivoter le bras depuis un rentrant de la chambre de traitement ou un compartiment séparé dans une position centrale au-dessus du plateau de maintien, l'entraînement de la broche étant de préférence monté sur la chambre de traitement sur le côté atmosphère ou sur le côté vide.

**13.** Système de traitement selon la revendication 12, comprenant en outre une unité de commande connectée à l'entraînement de broche et l'entraînement d'obturateur afin de coordonner le mouvement en rotation du bras et le mouvement linéaire z des broches pour faire pivoter le bras avec le disque et lever et abaisser le disque lorsque le bras se trouve dans la position centrale.

**14.** Procédé d'utilisation d'un agencement d'obturateur de processus selon l'une des revendications 1 à 8 dans une chambre d'un système de traitement sous vide selon la revendication 12 ou 13, comprenant les étapes suivantes consistant à :

- faire pivoter l'agencement dans un plan horizontal depuis le rentrant ou le compartiment séparé dans une position centrale au-dessus du plateau de maintien :
- étendre les broches pour lever le disque depuis la surface porteuse dans un plan horizontal au-dessus du bras ;
- faire pivoter le bras vide pour le ramener dans le rentrant ou le compartiment séparé ;
- abaisser et rétracter les broches dans la surface supérieure du plateau de maintien pour couvrir le plateau de maintien avec le disque ;
- réaliser une opération de conditionnement, de collage ou de service dans la chambre de traitement.

**15.** Procédé selon la revendication 14, comprenant en outre les étapes suivantes consistant à :

- étendre les broches pour lever le disque depuis le plateau de maintien dans le plan au-dessus du bras ;
- faire pivoter le bras vide depuis le rentrant ou le compartiment séparé dans la position centrale au-dessus du plateau de maintien et sous le disque ;
- abaisser les broches sur la surface porteuse de l'élément en forme de croissant, le positionnement de précision étant réalisé par la pénétration des tenons dans les mortaises ;
- rétracter les broches dans un plan horizontal sous le bras ;
- faire pivoter le bras chargé pour le ramener vers le rentrant ou le compartiment séparé.

**Fig. 1**

**Fig. 5**

**Fig. 2**

**Fig.3**

**Fig.4**

Fig.6

**Fig.7**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20020088771 A1
- US 7008517 B1
- US 2014271081 A1

- US 2012103793 A1
- WO 2017215806 A
- WO 2017207144 A1